# EUROPEAN PATENT APPLICATION

(11) **EP 2 963 689 A1**
(43) Date of publication of application: **06.01.2016**
(21) Application number: 14757703.5
(22) Date of filing: 26.02.2014
(51) Int. Cl.: H01L 31/042

(54) **SOLAR CELL MODULE AND METHOD FOR MANUFACTURING SAME**

(30) Priority: 27.02.2013 JP 2013036722
(71) Applicant: Zeon Corporation, Tokyo 100-8246 (JP)
(72) Inventor: KOIDE Yohei, Tokyo 100-8246 (JP); CHIBA Daido, Tokyo 100-8246 (JP); KOHARA Teiji, Tokyo 100-8246 (JP)
(74) Representative: Vossius & Partner Patentanwälte Rechtsanwälte mbB
(86) International application number: PCT/JP2014/054681
(87) International publication number: WO 2014/133003

(57) **Abstract**

Provided is a solar cell module comprising at least a front-side transparent glass, a sealing material layer that comprises an ethylene-vinyl acetate copolymer having a vinyl acetate content of 20 to 35 wt% as a main component, a crystalline silicon solar cell element that is embedded in the sealing material, and a back-side protective layer that is formed of a resin sheet or glass, the front-side transparent glass, the sealing material layer, the crystalline silicon solar cell element, and the back-side protective layer being stacked sequentially from a light-receiving side, a layer that is formed of a transparent resin and bonded to the front-side transparent glass being formed between the front-side transparent glass and the sealing material layer. This solar cell module is capable of suppressing the occurrence of PID using a sealing material formed of a general-purpose ethylene-vinyl acetate copolymer.

## Description

### TECHNICAL FIELD

The present invention relates to a solar cell module and a method for producing the same. More specifically, the invention relates to a solar cell module that utilizes a crystalline silicon element and can suppress occurrence of potential induced degradation (PID), and a method for producing the same.

### BACKGROUND ART

Photovoltaic power generation technology has attracted attention as power generation technology that utilizes clean energy. In recent years, photovoltaic power generation systems have been increased in scale (e.g., a mega solar system that utilizes solar cells). A large photovoltaic power generation system is designed so that the system voltage is set to as high as 600 to 1000 V in order to reduce a transmission loss. A large photovoltaic power generation system that utilizes a crystalline silicon solar cell has a problem in that PID may occur during long-term use due to a high voltage.

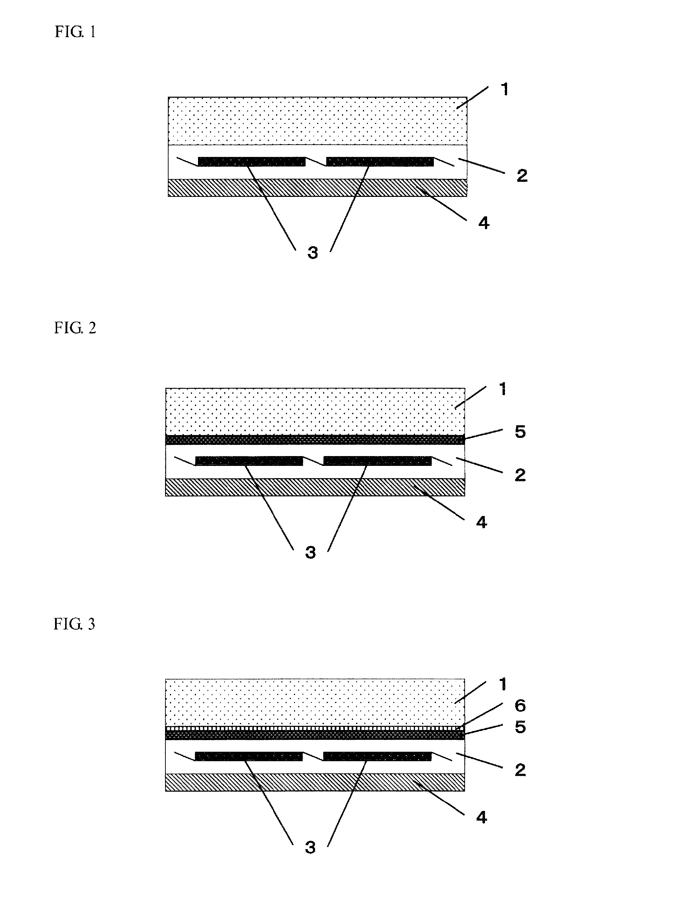

A crystalline silicon solar cell module normally has the structure illustrated in FIG 1 in which a sealing material 2 that includes an ethylene-vinyl acetate copolymer as the main component is bonded to a front-side transparent glass 1 in a state in which a crystalline silicon element 3 is embedded in the sealing material 2, and a back-side protective layer 4 that is formed of a resin sheet or glass is stacked on the other side of the sealing material 2. PID tends to occur when a solar cell module is used in a state in which a high voltage is applied between the solar cell module internal circuit (crystalline silicon element) and a frame that is grounded through the front-side transparent glass at a high temperature and a high humidity, and technology that can prevent occurrence of PID has been desired.

A method that uses a sealing material formed of an ethylene-α-olefin copolymer instead of a sealing material that includes an ethylene-vinyl acetate copolymer as the main component (see Patent Documents 1 to 3, for example), a method that uses a sealing material formed of an ethylene-α-olefin-nonconjugated polyene copolymer (see Patent Documents 4 and 5, for example), and the like have been proposed to suppress occurrence of PID.

An ethylene-vinyl acetate copolymer has been widely used as a solar cell sealing material, and technology, equipment, and the like for producing a solar cell module that utilizes a sealing material formed of an ethylene-vinyl acetate copolymer have been put to practical use.

Therefore, development of technology that suppresses or prevents occurrence of PID using a sealing material formed of a general-purpose ethylene-vinyl acetate copolymer without using a novel sealing material has been desired.

### RELATED-ART DOCUMENT

### PATENT DOCUMENT

Patent Document 1: JP-A-2012-238857
Patent Document 2: WO2012/046456
Patent Document 3: WO2012/060086
Patent Document 4: WO2012/066783
Patent Document 5: WO2012/070245

### SUMMARY OF THE INVENTION

### TECHNICAL PROBLEM

The inventors of the invention conducted extensive studies in order to provide a solar cell module that utilizes a crystalline silicon element and can suppress occurrence of PID even when a sealing material formed of a general-purpose ethylene-vinyl acetate copolymer is used. As a result, the inventors found that occurrence of PID can be suppressed or prevented by forming a layer that is formed of a transparent resin and bonded to glass between transparent glass and a sealing material that includes an ethylene-vinyl acetate copolymer as the main component. This finding has led to the completion of the invention.

### SOLUTION TO PROBLEM

According to a first aspect of the invention, a solar cell module includes at least a front-side transparent glass, a sealing material layer that includes an ethylene-vinyl acetate copolymer having a vinyl acetate content of 20 to 35 wt% as the main component, a crystalline silicon solar cell element that is embedded in the sealing material, and a back-side protective layer that is formed of a resin sheet or glass, the front-side transparent glass, the sealing material layer, the crystalline silicon solar cell element, and the back-side protective layer being stacked sequentially from the light-receiving side, a layer that is formed of a transparent resin and bonded to the front-side transparent glass being formed between the front-side transparent glass and the sealing material layer.

The layer that is formed of the transparent resin preferably has a thickness of 5 to 200 µm.

The transparent resin preferably has a volume resistivity at 25°C of 1 × 10¹⁴ Ω·cm or more.

The transparent resin is preferably at least one transparent resin selected from (1) a polyolefin, (2) a hydrogenated block copolymer obtained by hydrogenating 90% or more of the unsaturated bonds of a block copolymer that includes at least two polymer blocks [A] and at least one polymer block [B], the polymer block [A] including a repeating unit derived from an aromatic vinyl compound as the main component, and the polymer block [B] including a repeating unit derived from a linear conjugated diene compound as the main component, (3) an ethylene-(meth)acrylate copolymer, (4) an ionomer obtained by reacting an ethylene-unsaturated carboxylic acid random copolymer with a metal compound, (5) a methacrylate (co)polymer, (6) an ethylene-vinyl acetate copolymer having a vinyl acetate content of less than 20 wt%, and (7) a modified polymer obtained by introducing an alkoxysilyl group into at least one polymer selected from the polymers (1) to (6).

According to a second aspect of the invention, a method for producing the solar cell module includes sequentially stacking a sheet that is formed of a transparent resin, a sealing material sheet that includes an ethylene-vinyl acetate copolymer as the main component, a crystalline silicon solar cell element, a sealing material sheet that includes an ethylene-vinyl acetate copolymer as the main component, and a back-side protective material that is formed of a resin sheet or glass on a front-side transparent glass to obtain a laminate, and pressing the laminate with heating to integrate the laminate.

According to a third aspect of the invention, a method for producing the solar cell module includes stacking and securing a layer that is formed of a transparent resin on a front-side transparent glass, sequentially stacking a sealing material sheet that includes an ethylene-vinyl acetate copolymer as the main component, a crystalline silicon solar cell element, a sealing material sheet that includes an ethylene-vinyl acetate copolymer as the main component, and a back-side protective material that is formed of a resin sheet or glass on the front-side transparent glass on which the layer that is formed of the transparent resin is stacked to obtain a laminate, and pressing the laminate with heating to integrate the laminate.

### BRIEF DESCRIPTION OF DRAWINGS

FIG. 1 is a schematic view illustrating an example of a solar cell module.
FIG. 2 is a schematic view illustrating an example of a solar cell module according to a first embodiment of the invention.
FIG. 3 is a schematic view illustrating an example of a solar cell module according to a second embodiment of the invention.

### DESCRIPTION OF EMBODIMENTS

### (I) Solar cell module

A solar cell module according to one embodiment of the invention includes at least a front-side transparent glass, a sealing material layer that includes an ethylene-vinyl acetate copolymer having a vinyl acetate content of 20 to 35 wt% as the main component, a crystalline silicon solar cell element that is embedded in the sealing material, and a back-side protective layer that is formed of a resin sheet or glass, the front-side transparent glass, the sealing material layer, the crystalline silicon solar cell element, and the back-side protective layer being stacked sequentially from the light-receiving side, a layer that is formed of a transparent resin and bonded to the front-side transparent glass being formed between the front-side transparent glass and the sealing material layer.

### Transparent resin

The transparent resin that is used to form a layer between the front-side transparent glass and the sealing material is a resin that exhibits transparency, light resistance, and heat resistance desired for a solar cell, and exhibits excellent electrical insulating properties. It is preferable that the transparent resin have a total light transmittance of 70% or more, and more preferably 80% or more. It is preferable that the transparent resin have a volume resistivity at 25°C (i.e., an index of electrical insulating properties) of 10¹⁴ Ω·cm or more, and more preferably 10¹⁵ Ω·cm or more.

Specific examples of the transparent resin include a polyolefin such as an olefin homopolymer such as polyethylene, polypropylene, poly-1-butene, and poly-4-methylpentene; an ethylene-α-olefin copolymer such as an ethylene-propylene copolymer, an ethylene-1-butene copolymer, an ethylene-4-methylpentene copolymer, an ethylene-1-octene copolymer, and an ethylene-1-butene-1-octene copolymer; and an ethylene-α-olefin-nonconjugated diene copolymer such as an ethylene-propylene-dicyclopentadiene copolymer, an ethylene-propylene-5-ethylidene-2-norbornene copolymer, an ethylene-propylene-5-vinyl-2-norbornene copolymer, an ethylene-1-butene-dicyclopentadiene copolymer, an ethylene-1-butene-5-ethylidene-2-norbornene copolymer, and an ethylene-1-butene-vinylnorbornene copolymer; a cycloolefin polymer such as an ethylene-norbornene copolymer, an ethylene-tetracyclododecene copolymer, a hydrogenated ring-opening metathesis polymer of a norbornene derivative, and a cyclohexadiene polymer; a hydrogenated aromatic vinyl compound-conjugated diene copolymer obtained by hydrogenating the double bonds (derived from a diene and an aromatic compound) of an aromatic vinyl compound-conjugated diene random or block copolymer; an ethylene-(meth)acrylate copolymer such as an ethylene-methyl methacrylate copolymer, an ethylene-ethyl methacrylate copolymer, an ethylene-methyl acrylate copolymer, and an ethylene-ethyl acrylate copolymer; an ethylene-unsaturated carboxylic acid random copolymer and an ionomer obtained by reacting an ethylene-unsaturated carboxylic acid random copolymer with a metal compound; a polyester such as polyethylene terephthalate, polybutylene terephthalate, and polyethylene naphthalate; a polycarbonate; a styrene-based polymer such as polystyrene, a styrene-methyl methacrylate copolymer, and a styrene-acrylonitrile copolymer; a (meth)acrylate (co)polymer such as polymethyl methacrylate, polymethyl acrylate, a methyl methacrylate-glycidyl methacrylate copolymer, and a methyl methacrylate-tricyclodecyl methacrylate copolymer; an ethylene-vinyl acetate copolymer having a vinyl acetate content of 20 wt% or less; a halogen-based polymer such as polyvinyl chloride, polyvinylidene chloride, polyvinyl fluoride, polyvinylidene fluoride, and an ethylene-tetrafluoroethylene copolymer; a polyurethane; an epoxy resin; a silicone resin; an aromatic polymer such as a polyether ether ketone, a polysulfone, a polyether sulfone, a polyimide, and a polyarylate; a polyamide such as nylon 6, nylon 66, nylon 11, nylon 12, and nylon 6T; a curable polyisobutylene oligomer; a modified polymer obtained by introducing a carboxyl group, an acid anhydride group, an alkoxysilyl group, or the like into these polymers using an unsaturated carboxylic acid, an unsaturated carboxylic anhydride, an ethylenically unsaturated silane compound, or the like; and the like.

It is preferable to use (1) a polyolefin, (2) a hydrogenated block copolymer obtained by hydrogenating 90% or more of the unsaturated bonds of a block copolymer that includes at least two polymer blocks [A] and at least one polymer block [B], the polymer block [A] including a repeating unit derived from an aromatic vinyl compound as the main component, and the polymer block [B] including a repeating unit derived from a linear conjugated diene compound as the main component (hereinafter may be referred to as "specific hydrogenated block copolymer"), (3) an ethylene-(meth)acrylate copolymer, (4) an ionomer obtained by reacting an ethylene-unsaturated carboxylic acid random copolymer with a metal compound, (5) a methacrylate (co)polymer, (6) an ethylene-vinyl acetate copolymer having a vinyl acetate content of 20 wt% or less, and (7) a modified polymer obtained by introducing an alkoxysilyl group into these polymers, from the viewpoint of transparency and light resistance.

The transparent resins (1) to (7) that are preferably used in connection with one embodiment of the invention are described in detail below.

### (1) Polyolefin

The polyolefin that is preferably used in connection with one embodiment of the invention is an ethylene-based polyolefin that includes a structural unit derived from ethylene. It is preferable to use a polyolefin that includes a structural unit derived from ethylene in a ratio of 30 wt% or more, and more preferably 50 wt% or more, based on the total structural units.

Specific examples of such a polyolefin include an ethylene homopolymer and an ethylene-α-olefin copolymer.

The ethylene homopolymer that is preferably used in connection with one embodiment of the invention is linear or branched polyethylene that includes a structural unit derived from ethylene. Low-density polyethylene and linear low-density polyethylene are preferable from the viewpoint of transparency.

The ethylene-α-olefin copolymer that is preferably used in connection with one embodiment of the invention includes a structural unit derived from ethylene and a structural unit derived from an α-olefin having 3 or more carbon atoms.

The α-olefin is not particularly limited. An α-olefin that is copolymerizable with ethylene may be appropriately used. An α-olefin having 3 to 20 carbon atoms is normally used either alone or in combination with one or more additional α-olefins having 3 to 20 carbon atoms. It is preferable to use an α-olefin having 4 or more carbon atoms, and more preferably an α-olefin having 4 to 8 carbon atoms.

Specific examples of such an α-olefin include propylene, 1-butene, 1-pentene, 1-hexene, 4-methyl-1-pentene, 1-octene, 1-decene, 1-dodecene, and the like. Among these, 1-butene, 1-hexene, and 1-octene are preferable from the viewpoint of availability and a capability to produce a copolymer that exhibits excellent transparency.

The ethylene-α-olefin copolymer may be a random copolymer or a block copolymer. It is preferable that the ethylene-α-olefin copolymer be a random copolymer from the viewpoint of transparency.

Two or more ethylene-α-olefin copolymers may be used in combination.

The content of a structural unit derived from ethylene and the content of a structural unit derived from an α-olefin in the ethylene-α-olefin copolymer that is preferably used in connection with one embodiment of the invention are not particularly limited. The content of a structural unit derived from ethylene is normally 30 to 99 wt%, and preferably 50 to 90 wt%, and the content of a structural unit derived from an α-olefin having 3 or more carbon atoms is normally 10 to 70 wt%, and preferably 20 to 50 wt%. When the content of a structural unit derived from ethylene and the content of a structural unit derived from an α-olefin are within the above ranges, excellent transparency, light resistance, and the like can be obtained. The ethylene-α-olefin copolymer may include a copolymer component other than an α-olefin as long as the object of the invention is not impaired.

### (2) Specific hydrogenated block copolymer

The hydrogenated block copolymer (obtained by hydrogenating 90% or more of the unsaturated bonds of a block copolymer that includes at least two polymer blocks [A] and at least one polymer block [B], the polymer block [A] including a repeating unit derived from a specific aromatic vinyl compound as the main component, and the polymer block [B] including a repeating unit derived from a linear conjugated diene compound as the main component) that is preferably used in connection with one embodiment of the invention is a polymer that includes a structural unit derived from an aromatic vinyl compound having 8 to 20 carbon atoms that includes a vinyl group that is bonded directly to the aromatic ring, and a structural unit derived from a linear conjugated diene compound having 4 to 10 carbon atoms.

The polymer block [A] includes a repeating unit derived from an aromatic vinyl compound as the main component. The content of a repeating unit derived from an aromatic vinyl compound in the polymer block [A] is normally 90 wt% or more, preferably 95 wt% or more, and more preferably 99 wt% or more. The polymer block [A] may include either or both of a repeating unit derived from a linear conjugated diene compound and a repeating unit derived from an additional ethylenically unsaturated compound in addition to a repeating unit derived from an aromatic vinyl compound normally in a ratio of 10 wt% or less, preferably 5 wt% or less, and more preferably 1 wt% or less. When the content of a repeating unit derived from an aromatic vinyl compound in the polymer block [A] is within the above range, the resulting formed article exhibits excellent heat resistance.

A plurality of polymer blocks [A] may be either identical or different as long as the above range is satisfied.

The polymer block [B] includes a repeating unit derived from a linear conjugated diene compound as the main component. The content of a repeating unit derived from a linear conjugated diene compound in the polymer block [B] is normally 90 wt% or more, preferably 95 wt% or more, and more preferably 99 wt% or more. When the content of a repeating unit derived from a linear conjugated diene compound in the polymer block [B] is within the above range, the resulting formed article exhibits excellent flexibility and excellent impact resistance.

The polymer block [B] may include either or both of a repeating unit derived from an aromatic vinyl compound and a repeating unit derived from an additional ethylenically unsaturated compound in addition to a repeating unit derived from a linear conjugated diene compound normally in a ratio of 10 wt% or less, preferably 5 wt% or less, and more preferably 1 wt% or less. If the content of either or both of a repeating unit derived from an aromatic vinyl compound and a repeating unit derived from an additional ethylenically unsaturated compound in the polymer block [B] is high, the resulting formed article may exhibit insufficient flexibility and impact resistance.

When the block copolymer includes a plurality of polymer blocks [B], the plurality of polymer blocks [B] may be either identical or different as long as the above range is satisfied.

The aromatic vinyl compound may be one type of aromatic vinyl compound having 8 to 20 carbon atoms, or a combination of two or more types of aromatic vinyl compounds having 8 to 20 carbon atoms. It is preferable to use an aromatic vinyl compound having 8 to 12 carbon atoms. Specific examples of the aromatic vinyl compound include styrene, 3-methylstyrene, 4-methylstyrene, 4-methoxystyrene, 2,4-diisopropylstyrene, 2,4-dimethylstyrene, 4-t-butylstyrene, 5-t-butyl-2-methylstyrene, 1-vinylnaphthalene, 2-vinylnaphthalene, and the like. An aromatic vinyl compound that does not include a polar group is preferable from the viewpoint of hygroscopicity, and styrene is particularly preferable from the viewpoint of industrial availability.

The linear conjugated diene compound may be one type of linear conjugated diene compound having 4 to 10 carbon atoms, or may be a combination of two or more types of linear conjugated diene compounds having 4 to 10 carbon atoms. It is preferable to use a linear conjugated diene compound having 4 to 6 carbon atoms. Specific examples of the linear conjugated diene compound include 1,3-butadiene, isoprene, 2,3-dimethyl-1,3-butadiene, 1,3-pentadiene, and the like. A linear conjugated diene compound that does not include a polar group is preferable from the viewpoint of hygroscopicity, and 1,3-butadiene and isoprene are particularly preferable from the viewpoint of polymerization controllability.

Examples of the additional ethylenically unsaturated compound include a linear ethylenically unsaturated compound and a cyclic ethylenically unsaturated compound. These ethylenically unsaturated compounds may include a nitrile group, an alkoxycarbonyl group, a hydroxycarbonyl group, an acid anhydride group, or a halogen group. It is preferable that the additional ethylenically unsaturated compound does not include a polar group from the viewpoint of hygroscopicity. A linear olefin and a cycloolefin are more preferable, and a linear olefin is still more preferable. Examples of the linear olefin include ethylene, propylene, 1-butene, 1-pentene, 1-hexene, 1-heptene, 1-octene, 1-nonene, 1-decene, 1-dodecene, 1-eicosene, 4-methyl-1-pentene, 4,6-dimethyl-1-heptene, and the like. Examples of the cycloolefin include vinylcyclohexane and the like. Among these, ethylene and propylene are particularly preferable.

The number of polymer blocks [A] included in the block copolymer is normally 4 or less, preferably 3 or less, and more preferably 2. The number of polymer blocks [B] included in the block copolymer is normally 3 or less, preferably 2 or less, and more preferably 1. When the block copolymer includes a plurality of polymer blocks [A], the ratio (Mw(A1)/Mw(A2)) of the highest weight average molecular weight Mw(A1) to the lowest weight average molecular weight Mw(A2) among the weight average molecular weights of the plurality of polymer blocks [A] is preferably 2.0 or less, more preferably 1.5 or less, and still more preferably 1.2 or less. When the block copolymer includes a plurality of polymer blocks [B], the ratio (Mw(B1)/Mw(B2)) of the highest weight average molecular weight Mw(B1) to the lowest weight average molecular weight Mw(B2) among the weight average molecular weights of the plurality of polymer blocks [B] is preferably 2.0 or less, more preferably 1.5 or less, and still more preferably 1.2 or less.

The block copolymer [1] may be a chain block copolymer or a radial block copolymer. It is preferable that the block copolymer be a chain block copolymer since the block copolymer exhibits excellent mechanical strength. It is most preferable that the block copolymer [1] be a triblock copolymer in which the polymer block [A] is bonded to each terminal (end) of the polymer block [B].

The ratio (wA:wB) of the weight fraction wA of the polymer block [A] in the block copolymer to the weight fraction wB of the polymer block [B] in the block copolymer is preferably 20:80 to 65:35, more preferably 30:70 to 60:40, and still more preferably 40:60 to 55:45. When the ratio (wA:wB) is within the above range, the resulting formed article exhibits excellent heat resistance, excellent flexibility, and the like.

The specific hydrogenated block copolymer that is preferably used in connection with one embodiment of the invention is obtained by hydrogenating the carbon-carbon unsaturated bonds included in the main chain, the side chain, and the aromatic ring of the block copolymer. The hydrogenation ratio of the specific hydrogenated block copolymer is normally 90% or more, preferably 97% or more, and more preferably 99% or more. The resulting formed article exhibits better weatherability and heat resistance as the hydrogenation ratio increases.

The unsaturated bond hydrogenation method, the reaction configuration, and the like are not particularly limited. It is preferable to use a hydrogenation method that can increase the hydrogenation ratio, and causes a polymer chain cleavage reaction to only a small extent. Examples of such a hydrogenation method include the methods disclosed in WO2011/096389, WO2012/043708, and the like.

### (3) Ethylene-(meth)acrylate copolymer

The ethylene-(meth)acrylate copolymer that is preferably used in connection with one embodiment of the invention is a polymer that includes a structural unit derived from ethylene, and either or both of a structural unit derived from an acrylate and a structural unit derived from a methacrylate.

The acrylate and/or the methacrylate are not particularly limited. An acrylate and/or a methacrylate that is copolymerizable with ethylene may be appropriately used. An acrylate and/or a methacrylate having 4 to 20 carbon atoms is normally used either alone or in combination with one or more additional acrylates and/or methacrylates having 4 to 20 carbon atoms. An acrylate and/or a methacrylate having 4 to 10 carbon atoms is preferable. Specific examples of the acrylate and/or the methacrylate include methyl acrylate, ethyl acrylate, propyl acrylate, butyl acrylate, glycidyl acrylate, 2-hydroxyethyl acrylate, benzyl acrylate, methyl methacrylate, ethyl methacrylate, propyl methacrylate, butyl methacrylate, glycidyl methacrylate, 2-hydroxyethyl methacrylate, benzyl methacrylate, and the like. Among these, methyl methacrylate and butyl methacrylate are particularly preferable from the viewpoint of availability and a capability to produce a copolymer that exhibits excellent transparency and excellent heat resistance.

The ethylene-(meth)acrylate copolymer may be a random copolymer or a block copolymer. It is preferable that the ethylene-(meth)acrylate copolymer be a random copolymer from the viewpoint of transparency. Each ethylene-(meth)acrylate copolymer may be used either alone or in combination with one or more additional ethylene-(meth)acrylate copolymers.

The content of a structural unit derived from ethylene in the ethylene-(meth)acrylate copolymer that is preferably used in connection with one embodiment of the invention is normally 70 to 99 wt%, and preferably 80 to 95 wt%, based on the total structural units. The content of a structural unit derived from a (meth)acrylate in the ethylene-(meth)acrylate copolymer is normally 1 to 30 wt%, and preferably 5 to 20 wt%, based on the total structural units. When the content of a structural unit derived from ethylene and the content of a structural unit derived from a (meth)acrylate are within the above ranges, the resulting formed article exhibits excellent transparency and excellent heat resistance.

### (4) Ionomer obtained by reacting ethylene-unsaturated carboxylic acid random copolymer with metal compound

The ionomer that is preferably used in connection with one embodiment of the invention is obtained by reacting an ethylene-unsaturated carboxylic acid copolymer with a metal compound (i.e., ion source) while melt-mixing the ethylene-unsaturated carboxylic acid copolymer in a screw extruder.

Specific examples of the unsaturated carboxylic acid used to produce the ethylene-unsaturated carboxylic acid copolymer include acrylic acid, methacrylic acid, maleic anhydride, monomethyl maleate, and the like. These unsaturated carboxylic acids are used either alone or in combination. Among these, acrylic acid and methacrylic acid are preferable due to high reactivity.

The content of a structural unit derived from ethylene in the ethylene-unsaturated carboxylic acid copolymer that is preferably used in connection with one embodiment of the invention is normally 60 to 96 wt%, and preferably 70 to 90 wt%, based on the total structural units. The content of a structural unit derived from an unsaturated carboxylic acid in the ethylene-unsaturated carboxylic acid copolymer that is preferably used in connection with one embodiment of the invention is normally 4 to 40 wt%, and preferably 10 to 30 wt%, based on the total structural units. When the content of a structural unit derived from ethylene and the content of a structural unit derived from an unsaturated carboxylic acid are within the above ranges, excellent transparency, mechanical strength, processability, and the like can be obtained. The ethylene-unsaturated carboxylic acid copolymer may be a copolymer produced by copolymerizing ethylene and an unsaturated carboxylic acid together with an additional component such as an acrylate or a methacrylate (e.g., methyl acrylate, ethyl acrylate, butyl acrylate, methyl methacrylate, or ethyl methacrylate).

Examples of the metal compound (ion source) include a metal oxide, a metal hydroxide, a metal carbonate, a metal bicarbonate, a metal acetate, a metal formate, and the like. Examples of the metal include an alkali metal atom such as lithium, sodium, and potassium; an alkaline-earth metal such as magnesium, calcium, and barium; a transition metal such as zinc, cobalt, chromium, and copper; and a main-group metal such as aluminum. The amount (stoichiometric amount) of the metal compound (ion source) is not particularly limited as long as the carboxyl groups included in the ethylene-unsaturated carboxylic acid copolymer are neutralized to the desired degree. For example, the metal compound is used so that the degree of neutralization is 10 to 90%.

### (5) Methacrylate (co)polymer

The methacrylate (co)polymer that is preferably used in connection with one embodiment of the invention is a polymer that includes a structural unit derived from methyl methacrylate and optionally a structural unit derived from a methacrylate other than methyl methacrylate and/or an acrylate.

The methacrylate and/or the acrylate that are optionally used are not particularly limited. An appropriate methacrylate and/or an appropriate acrylate may be used taking account of the required properties. A methacrylate and/or acrylate having 4 to 20 carbon atoms is normally used either alone or in combination with one or more additional methacrylates and/or acrylates having 4 to 20 carbon atoms. Specific examples of the methacrylate and/or the acrylate include methyl acrylate, ethyl acrylate, propyl acrylate, butyl acrylate, glycidyl acrylate, 2-hydroxyethyl acrylate, benzyl acrylate, ethyl methacrylate, propyl methacrylate, butyl methacrylate, glycidyl methacrylate, 2-hydroxyethyl methacrylate, benzyl methacrylate, and the like.

The content of a structural unit derived from methyl methacrylate in the methacrylate (co)polymer that is preferably used in connection with one embodiment of the invention is normally 60 wt% or more based on the total structural units. The content of a structural unit derived from a methacrylate and/or an acrylate (optional) in the methacrylate (co)polymer that is preferably used in connection with one embodiment of the invention is normally 40 % or less based on the total structural units. When the content of a structural unit derived from methyl methacrylate and the content of a structural unit derived from a methacrylate and/or an acrylate are within the above ranges, excellent transparency, light resistance, and the like can be obtained.

### (6) Ethylene-vinyl acetate polymer

The ethylene-vinyl acetate copolymer that is preferably used in connection with one embodiment of the invention includes a repeating unit derived from ethylene and a repeating unit derived from vinyl acetate in the molecule, and has a content of a repeating unit derived from vinyl acetate of less than 20 wt%. It is possible to improve heat resistance and electrical insulating properties by reducing the content of a repeating unit derived from vinyl acetate. In this case, however, a deterioration in transparency may occur. The content of a repeating unit derived from vinyl acetate in the ethylene-vinyl acetate copolymer is normally 1 to 19 wt%, and preferably 5 to 10 wt%. When the content of a structural unit derived from vinyl acetate is within the above range, excellent transparency, heat resistance, electrical insulating properties, and the like can be obtained.

### (7) Modified polymer obtained by introducing alkoxysilyl group into at least one polymer selected from polymers (1) to (6)

The modified polymer that is preferably used in connection with one embodiment of the invention is obtained by introducing an alkoxysilyl group into at least one polymer selected from the polymers (1) to (6). The polymer exhibits improved adhesion to glass as a result of introducing an alkoxysilyl group into the polymer. The alkoxysilyl group may be bonded directly to at least one polymer selected from the polymers (1) to (6), or may be bonded to at least one polymer selected from the polymers (1) to (6) through a divalent organic group (e.g., alkylene group).

It is preferable to introduce an alkoxysilyl group by reacting at least one polymer selected from the polymers (1) to (6) with an ethylenically unsaturated silane compound in the presence of a peroxide.

The amount of alkoxysilyl groups introduced into at least one polymer selected from the polymers (1) to (6) is normally 0.1 to 10 parts by weight, preferably 0.2 to 5 parts by weight, and more preferably 0.3 to 3 parts by weight, based on 100 parts by weight of at least one polymer selected from the polymers (1) to (6). If the amount of alkoxysilyl groups introduced is too large, the alkoxysilyl groups that are decomposed due to a small amount of water or the like may be crosslinked to a large extent (before melt-forming the transparent resin into the desired sheet shape), whereby gelation may occur, or a decrease in formability due to a decrease in melt-flowability may occur, for example. If the amount of alkoxysilyl groups introduced is too small, adhesion to glass may not be significantly improved.

The ethylenically unsaturated silane compound is not particularly limited as long as an alkoxysilyl group can be introduced into at least one polymer selected from the polymers (1) to (6) by subjecting the ethylenically unsaturated silane compound to graft polymerization with at least one polymer selected from the polymers (1) to (6). Examples of a preferable ethylenically unsaturated silane compound include vinyltrimethoxysilane, vinyltriethoxysilane, allyltrimethoxysilane, allyltriethoxysilane, dimethoxymethylvinylsilane, diethoxymethylvinylsilane, and p-styryltrimethoxysilane.

These ethylenically unsaturated silane compounds may be used either alone or in combination. The ethylenically unsaturated silane compound is normally used in an amount of 0.1 to 10 parts by weight, preferably 0.2 to 5 parts by weight, and more preferably 0.3 to 3 parts by weight, based on 100 parts by weight of at least one polymer selected from the polymers (1) to (6).

A compound having a one-minute half-life temperature of 170 to 190°C is preferably used as the peroxide. For example, t-butylcumyl peroxide, dicumyl peroxide, di-t-hexyl peroxide, 2,5-dimethyl-2,5-di(t-butylperoxy)hexane, di-t-butyl peroxide, and the like are preferably used.

These peroxides may be used either alone or in combination. The peroxide is normally used in an amount of 0.05 to 2 parts by weight, preferably 0.1 to 1 part by weight, and more preferably 0.2 to 0.5 parts by weight, based on 100 parts by weight of at least one polymer selected from the polymers (1) to (6).

At least one polymer selected from the polymers (1) to (6) and the ethylenically unsaturated silane compound may be reacted in the presence of the peroxide using an arbitrary method. For example, at least one polymer selected from the polymers (1) to (6) and the ethylenically unsaturated silane compound may be kneaded (mixed) at the desired temperature for the desired time using a twin-screw kneader to introduce an alkoxysilyl group. The kneading temperature is normally 180 to 220°C, preferably 185 to 210°C, and more preferably 190 to 200°C. The kneading (heating) time is normally 0.1 to 10 minutes, preferably 0.2 to 5 minutes, and more preferably about 0.3 to 2 minutes. The mixture may be continuously kneaded and extruded so that the temperature and the residence time are within the above ranges.

### Solar cell module

The solar cell module according to one embodiment of the invention includes at least a front-side transparent glass, a layer that is formed of a transparent resin and bonded to the front-side transparent glass, a sealing material layer that includes an ethylene-vinyl acetate copolymer as the main component, a crystalline silicon solar cell element that is embedded in the sealing material, and a back-side protective layer that is formed of a resin sheet or glass, the front-side transparent glass, the layer that is formed of the transparent resin, the sealing material layer, the crystalline silicon solar cell element, and the back-side protective layer being stacked sequentially from the light-receiving side.

The details of the solar cell module are described below with reference to the drawings.

FIG. 2 illustrates a preferable example (embodiment) of the solar cell module. Note that the following examples (embodiments) are for illustration purposes only, and the scope of the invention is not limited to the following examples (embodiments) unless otherwise stated.

The solar cell module illustrated in FIG. 2 has a structure in which a front-side transparent glass 1, a transparent resin layer 5, a sealing material layer 2 that includes an ethylene-vinyl acetate copolymer as the main component, a crystalline silicon solar cell element 3 that is embedded in the sealing material, and a back-side protective layer 4 are sequentially stacked from the sunlight-receiving side (light-receiving side or sunlight incidence side).

Examples of the crystalline silicon solar cell element 3 include a monocrystalline silicon solar cell element and a polycrystalline silicon solar cell element.

The front-side transparent glass 1 is not particularly limited as long as the front-side transparent glass 1 is translucent (i.e., allows light to pass through). Specific examples of the front-side transparent glass 1 include white sheet glass, soda glass, silica glass, fused silica glass, borosilicate glass, and the like. The solar cell module according to one embodiment of the invention can suppress occurrence of PID even when soda glass that is inexpensive and industrially advantageous is used as the front-side transparent glass 1.

The transparent resin layer 5 is a layer that is formed using the transparent resin (see above). The thickness of the transparent resin layer 5 is normally 5 to 200 µm, and preferably 10 to 100 µm. If the thickness of the transparent resin layer 5 is less than 5 µm, the effect of suppressing occurrence of PID may be insufficient. If the thickness of the transparent resin layer 5 exceeds 200 µm, a decrease in light transmittance may occur, and it is uneconomical.

The transparent resin that forms the transparent resin layer 5 may include a light stabilizer, a UV absorber, a silane coupling agent, and the like so that light resistance and adhesion to glass are improved.

As illustrated in FIG. 3, the transparent resin layer 5 may be bonded to the front-side transparent glass through an adhesive layer 6. It is preferable to form the adhesive layer 6 using an adhesive that exhibits excellent light resistance and excellent heat resistance. Examples of such an adhesive include a silicone-based adhesive, an acrylic-based adhesive, an epoxy-based adhesive, a urethane-based adhesive, an ethylene-vinyl acetate copolymer-based adhesive, and the like.

Since the adhesive layer easily yellows when light is applied for a long time, it is preferable that the adhesive layer have a small thickness. The thickness of the adhesive layer is normally 20 µm or less, and preferably 10 µm or less.

The sealing material layer 2 that includes an ethylene-vinyl acetate copolymer as the main component is formed by mixing a silane coupling agent, a peroxide, a crosslinking promoter, a light stabilizer, a UV absorber, and the like into an ethylene-vinyl acetate copolymer to prepare a sealing material sheet, and crosslinking the sealing material sheet by heating the sealing material sheet under pressure.

The ethylene-vinyl acetate copolymer used to form the solar cell sealing material has a content of a structural unit derived from ethylene of 65 to 80 wt%, and a content of a structural unit derived from vinyl acetate of 20 to 35 wt%.

The silane coupling agent that may be added to the solar cell sealing material is useful for improving adhesion to the glass substrate (base), the crystalline silicon solar cell element, and the like. Specific examples of the silane coupling agent include N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane, and the like. The silane coupling agent is normally used in an amount of 0.01 to 5 parts by weight based on 100 parts by weight of the ethylene-vinyl acetate copolymer.

The peroxide that may be added to the solar cell sealing material is preferably an organic peroxide that has a decomposition temperature (i.e., a temperature at which the half-life is 1 hour) of 90 to 180°C, and more preferably 110 to 160°C.

Specific examples of such an organic peroxide include tert-butylperoxy isopropyl carbonate, tert-butylperoxy acetate, tert-butylperoxy benzoate, dicumyl peroxide, 2,5-dimethyl 2,5-bis(tert-butylperoxy)hexane, di-tert-butyl peroxide, 2,5-dimethyl-2,5-bis(tert-butylperoxy)hexyne-3, 1,1-bis(tert-butylperoxy)-3,3,5-trimethylcyclohexane, 1,1-bis(tert-butylperoxy)cyclohexane, methyl ethyl ketone peroxide, 2,5-dimethylhexyl-2,5-bisperoxybenzoate, tert-butyl hydroperoxide, p-menthane hydroperoxide, benzoyl peroxide, p-chlorobenzoyl peroxide, tert-butylperoxy isobutyrate, hydroxyheptyl peroxide, dicyclohexanone peroxide, and the like. The amount of the peroxide is determined taking account of the type of the peroxide. The peroxide is normally used in an amount of about 0.05 to 5 parts by weight, and preferably about 0.1 to 3 parts by weight, based on 100 parts by weight of the ethylene-vinyl acetate copolymer.

The crosslinking promoter that may be added to the solar cell sealing material is used to improve the degree of crosslinking of the sealing material and provide the sealing material with heat resistance. Examples of the crosslinking promoter include a polyunsaturated compound such as a polyallyl compound and a poly(meth)acryloxy compound. Specific examples of the crosslinking promoter include a polyallyl compound such as triallyl isocyanurate, triallyl cyanurate, diallyl phthalate, diallyl fumarate, and diallyl maleate, a poly(meth)acryloxy compound such as ethylene glycol diacrylate, ethylene glycol dimethacrylate, and trimethylolpropane trimethacrylate, divinylbenzene, and the like. It is effective to use the crosslinking promoter in an amount of about 0.5 to 5 parts by weight based on 100 parts by weight of the ethylene-based copolymer.

The light stabilizer and the UV absorber that may be added to the solar cell sealing material are important for improving long-term durability. Examples of the light stabilizer and the UV absorber include a hindered amine-based compound, a benzophenone-based compound, a benzotriazole-based compound, a triazine-based compound, a salicylate-based compound, and the like. The amount of the light stabilizer and the amount of the UV absorber are determined taking account of the type of the light stabilizer and the type of the UV absorber. The light stabilizer and the UV absorber are normally used in an amount of about 0.01 to 5 parts by weight, and preferably about 0.1 to 1 part by weight, based on 100 parts by weight of the ethylene-vinyl acetate copolymer.

The back-side protective layer 4 is formed using a sheet formed of a resin (e.g., polyethylene terephthalate, polyvinyl fluoride, polyolefin, and nylon); a sheet obtained by stacking these sheets; a sheet obtained by depositing an inorganic compound on a sheet formed of a resin in order to improve water vapor barrier properties; a sheet obtained by stacking a resin sheet and an aluminum foil; a resin sheet to which a white pigment is added in order to reflect light; or the like. The thickness of the back-side protective layer 5 is normally 100 to 600 µm, and preferably 200 to 400 µm. If the thickness of the back-side protective layer 4 is less than 100 µm, the partial discharge voltage may decrease. If the thickness of the back-side protective layer 4 exceeds 600 µm, it is uneconomical.

The back-side protective layer 4 may be formed of transparent glass. When glass is used as the material for forming the back-side protective layer 4, the solar cell module has transparency in an area in which the crystalline silicon solar cell element is not disposed. In this case, the solar cell module may be used as a roof material or a wall material that exhibits translucency. When glass is used as the material for forming the back-side protective layer 4, a transparent resin layer may not be formed on the back-side glass.

### Method for producing solar cell module

The solar cell module according to one embodiment of the invention may be produced using a method (α) that sequentially stacks a sheet formed of the transparent resin, a sealing material sheet that includes an ethylene-vinyl acetate copolymer as the main component, the crystalline silicon solar cell element, a sealing material sheet that includes an ethylene-vinyl acetate copolymer as the main component, and the back-side protective sheet or back-side protective glass on the front-side transparent glass, and presses the laminate with heating using a vacuum laminator or the like to integrate the laminate, a method (β) that stacks (secures) a layer formed of the transparent resin on the front-side transparent glass, sequentially stacks a sealing material sheet that includes an ethylene-vinyl acetate copolymer as the main component, the crystalline silicon solar cell element, a sealing material sheet that includes an ethylene-vinyl acetate copolymer as the main component, and the back-side protective sheet or back-side protective glass on the transparent resin layer, and presses the laminate with heating using a vacuum laminator or the like to integrate the laminate, or the like.

When using the method (α), each member can be stacked with good operability when the sheet formed of the transparent resin has a thickness of about 40 to 200 µm. When using the method (β), a layer formed of the transparent resin may be formed on the front-side transparent glass using a method that stacks a layer formed of the transparent resin on the front-side transparent glass, or a method that applies a solution (in which the transparent resin is dissolved) or an aqueous emulsion (in which the transparent resin is finely dispersed) to the surface of the front-side transparent glass, and dries the resulting film to form a thin transparent resin layer having a thickness of about 5 to 50 µm.

The heating temperature when integrating the laminate (that forms the solar cell module according to one embodiment of the invention) using a vacuum laminator or the like is normally 120 to 180°C, and preferably 140 to 160°C. The pressure is normally set to 0.1 MPa or less. Note that the pressure may be appropriately reduced when the sealing material has high fluidity.

### EXAMPLES

The invention is further described below by way of examples and comparative examples. Note that the invention is not limited to the following examples. In the examples and the comparative examples, the unit "parts" refers to "parts by weight", and the unit "%" refers to "wt%", unless otherwise indicated.

The following property measurement methods were used in the examples and the comparative examples.

### (1) Volume resistivity

The volume resistivity at 25°C was measured in accordance with JIS C 2139 using a transparent resin and a crosslinked sealing material (thickness: 0.9 to 1.2 mm).

### (2) PID test

A solar cell module was produced by integrally stacking a layer formed of a transparent resin, a sealing material layer including an ethylene-vinyl acetate copolymer as the main component, a crystalline silicon solar cell element embedded in the sealing material, and a back-side protective layer on a front-side transparent glass (white glass sheet (thickness: 3 mm) or soda glass sheet).

The solar cell module was allowed to stand at a high temperature (60°C) and a high humidity (85%RH (relative humidity)) so that water was present on the surface of the glass. The aluminum frame was grounded, and a DC voltage of 1000 V was applied between the positive terminal and the negative terminal for 96 hours. After removing the solar cell module, the I-V characteristics were measured using a solar simulator ("PVS 1116i" manufactured by Nisshinbo Mechatronics Inc.), and the maximum output (Pm) was evaluated.

The ratio (Pm/Pm₀) of the maximum output (Pm) to the initial output (Pm₀) was calculated, and taken as the retention ratio.

### Reference Example 1

### Sheet formed of modified polyethylene

1.5 parts of vinyltrimethoxysilane and 0.15 parts of 2,5-dimethyl-2,5-di(t-butylperoxy)hexane were added to 100 parts of pellets of commercially-available low-density polyethylene ("Novatec (registered trademark) LF342M1" manufactured by Japan Polyethylene Corporation, melting point: 113°C) to prepare a mixture. The mixture was kneaded using a twin-screw extruder ("TEM37B" manufactured by Toshiba Machine Co., Ltd.) (resin temperature: 200°C, residence time: 80 to 90 seconds), extruded in the shape of a strand, cooled with air, and finely cut using a pelletizer to obtain 97 parts of pellets of modified polyethylene (PE-S).

The FT-IR spectrum of the resulting pellets was measured. An absorption peak attributed to an Si-OCH₃ group was observed at 1,090 cm⁻¹, and an absorption peak attributed to an Si-CH₂ group was observed at 825 cm⁻¹ and 739 cm⁻¹. These absorption peaks were observed at positions differing from those (1,075 cm⁻¹, 808 cm⁻¹, and 766 cm⁻¹) of vinyltrimethoxysilane. It was thus confirmed that the modified polyethylene (PE-S) included a methoxysilyl group.

0.4 parts of 2-(2H-benzotriazol-2-yl)-4-(1,1,3,3-tetramethylbutyl)phenol ("Tinuvin (registered trademark) 329" manufactured by BASF Japan Ltd.) (UV absorber) was added to 100 parts of the pellets of the modified polyethylene (PE-S) to prepare a mixture. The mixture was extruded into a sheet (PE-S-F5) having a thickness of 50 µm and a width of 500 mm using a T-die film molding device (width of T-die: 600 mm) having a resin melt-extrusion device provided with a screw having a diameter of 40 mm and a film take-up device provided with an embossing roll (molten resin temperature: 200°C, T-die temperature: 200°C, embossing roll temperature: 50°C) while pressing one side of the extruded sheet against the embossing roll using a touch roll. The extruded sheet was wound around a roll.

A sheet (PE-S-F2) having a thickness of 20 µm and a width of 500 mm was formed by extrusion under the same conditions while changing the film take-up speed and feeding a PET film having a thickness of 75 µm as an interleaf.

Twenty sheets (PE-S-F5) (formed of the modified polyethylene) were stacked, and pressed (formed) at 150°C under vacuum using a vacuum laminator to obtain a specimen (sheet) having a thickness of about 1 mm. The volume resistivity measured using the resulting specimen was 1×10¹⁶ Ω·cm cm or more.

### Reference Example 2

### Sheet formed of modified ethylene-α-olefin copolymer

90 parts of pellets of a modified ethylene-1-octene copolymer (EOC-S) were obtained in the same manner as in Reference Example 1, except that pellets of a commercially-available ethylene-octene copolymer ("Affinity (registered trademark) PL1880" manufactured by Dow Chemical Japan Ltd., melting point: 100°C) were used, the resin temperature was set to 190°C, and the residence time was set to 170 to 180 seconds.

The FT-IR spectrum of the resulting pellets was measured. An absorption peak attributed to an Si-OCH₃ group was observed at 1,090 cm⁻¹, and an absorption peak attributed to an Si-CH₂ group was observed at 825 cm⁻¹ and 739 cm⁻¹. These absorption peaks were observed at positions differing from those (1,075 cm⁻¹, 808 cm⁻¹, and 766 cm⁻¹) of vinyltrimethoxysilane. It was thus confirmed that the modified ethylene-1-octene copolymer (EOC-S) included a methoxysilyl group.

A sheet (EOC-S-F) having a thickness of 50 µm and a width of 500 mm was obtained in the same manner as in Reference Example 1, except that the pellets of the modified ethylene-1-octene copolymer (PEO-S) were used, the molten resin temperature was set to 190°C, and the T-die temperature was set to 190°C.

Twenty sheets (EOC-S-F) (formed of the modified ethylene-1-octene copolymer) were stacked, and pressed (formed) at 150°C under vacuum using a vacuum laminator to obtain a specimen (sheet) having a thickness of about 1 mm. The volume resistivity measured using the resulting specimen was 1×10¹⁶ Ω·cm or more.

### Reference Example 3

### Sheet formed of modified hydrogenated block copolymer

A modified hydrogenated block copolymer was synthesized in the same manner as in WO2012/043708.

Specifically, 2.0 parts of vinyltrimethoxysilane and 0.2 parts of 2,5-dimethyl-2,5-di(t-butylperoxy)hexane were added to 100 parts by weight of a hydrogenated block copolymer obtained by hydrogenating about 100% of the unsaturated bonds of a block copolymer (polystyrene block [1]-polyisoprene block [2]-polystyrene block [3], the weight ratio of block [1]:block [2]:block [3] was 25:50:25) to prepare a mixture. The mixture was kneaded in the same manner as in Reference Example 1 to obtain 95 parts of pellets of a modified hydrogenated block copolymer (HBC-S).

The FT-IR spectrum of the resulting pellets was measured. An absorption peak attributed to an Si-OCH₃ group was observed at 1,090 cm⁻¹, and an absorption peak attributed to an Si-CH₂ group was observed at 825 cm⁻¹ and 739 cm⁻¹. These absorption peaks were observed at positions differing from those (1,075 cm⁻¹, 808 cm⁻¹, and 766 cm⁻¹) of vinyltrimethoxysilane. It was thus confirmed that the modified hydrogenated block copolymer (HBC-S) included a methoxysilyl group.

A sheet (HBC-S-F) having a thickness of 50 µm and a width of 500 mm was obtained in the same manner as in Reference Example 1, except that the pellets of the modified hydrogenated block copolymer (HBC-S) were used, the molten resin temperature was set to 220°C, the T-die temperature was set to 200°C, and the embossing roll temperature was set to 80°C.

Twenty sheets (HBC-S-F) (formed of the modified hydrogenated block copolymer) were stacked, and pressed (formed) at 150°C under vacuum using a vacuum laminator to obtain a specimen (sheet) having a thickness of about 1 mm. The volume resistivity measured using the resulting specimen was 1×10¹⁶ Ω·cm or more.

### Reference Example 4

### Sheet formed of modified ethylene-(meth)acrylate copolymer

93 parts of pellets of a modified ethylene-ethyl acrylate copolymer (EEAC-S) were obtained in the same manner as in Reference Example 1, except that pellets of a commercially-available modified ethylene-ethyl acrylate copolymer ("NUC-6221" manufactured by Nippon Unicar Co., Ltd., ethyl acrylate content: 10 wt%, melting point: 96°C) were used, the resin temperature was set to 190°C, and the residence time was set to 170 to 180 seconds.

The FT-IR spectrum of the resulting pellets was measured. An absorption peak attributed to an Si-OCH₃ group was observed at 1,090 cm⁻¹, and an absorption peak attributed to an Si-CH₂ group was observed at 825 cm⁻¹ and 739 cm⁻¹. These absorption peaks were observed at positions differing from those (1,075 cm⁻¹, 808 cm⁻¹, and 766 cm⁻¹) of vinyltrimethoxysilane. It was thus confirmed that the modified ethylene-ethyl acrylate copolymer (EEAC-S) included a methoxysilyl group.

A sheet (EEAC-S-F) having a thickness of 50 µm and a width of 500 mm was obtained in the same manner as in Reference Example 1, except that the pellets of the modified ethylene-ethyl acrylate copolymer (EEAC-S) were used, the molten resin temperature was set to 190°C, and the T-die temperature was set to 190°C.

Twenty sheets (EEAC-S-F) (formed of the modified ethylene-ethyl acrylate copolymer) were stacked, and pressed (formed) at 150°C under vacuum using a vacuum laminator to obtain a specimen (sheet) having a thickness of about 1 mm. The volume resistivity measured using the resulting specimen was 9.2×10¹⁵ Ω·cm.

### Reference Example 5

### Sheet formed of ionomer resin

0.4 parts of 2-(2H-benzotriazol-2-yl)-4-(1,1,3,3-tetramethylbutyl)phenol ("Tinuvin (registered trademark) 329" manufactured by BASF Japan Ltd.) was added to 100 parts of pellets of a commercially-available ionomer resin (ethylene-methacrylic acid copolymer, counter ion: Zn) ("HIMILAN (registered trademark) 1652" manufactured by DuPont-Mitsui Polychemicals Co., Ltd., melting point: 98°C) to prepare a mixture. The mixture was extruded into a sheet (EMAI-F) having a thickness of 50 µm and a width of 500 mm using a T-die film molding device and a film take-up device (see Reference Example 1) (molten resin temperature: 175°C, T-die temperature: 175°C, embossing roll temperature: 50°C) while embossing the sheet.

Twenty sheets (EMAI-F) (formed of the ionomer resin) were stacked, and pressed (formed) at 150°C under vacuum using a vacuum laminator to obtain a specimen (sheet) having a thickness of about 1 mm. The volume resistivity measured using the resulting specimen was 1×10¹⁶ Ω·cm or more.

### Reference Example 6

### Plastisol of methacrylate (co)polymer

A reactor made of stainless steel was charged with 50 parts by weight of methyl methacrylate, 20 parts by weight of n-butyl acrylate, 1 part by weight of a sodium alkyl sulfate including an alkyl group having 12 to 18 carbon atoms, 0.1 parts by weight of potassium persulfate, and 150 parts by weight of distilled water. The mixture was subjected to emulsion polymerization at 50°C with stirring. The resulting latex (average primary particle size: 0.40 µm) was used as a seed for seed polymerization. After the addition of 35 parts by weight of methyl methacrylate, 5 parts by weight of glycidyl methacrylate, and 0.1 parts by weight of t-dodecylmercaptan, the mixture was subjected to polymerization at 50°C. The reaction was terminated when the polymerization ratio had reached 92% to obtain a latex (average primary particle size: 0.45 µm, solid content: 39.8 wt%).

100 parts by weight of the resulting latex was heated to 60°C, and added to a coagulant (300 parts by weight of a 1.0% aluminum sulfate aqueous solution) heated at 60°C in a coagulation vessel with stirring to effect coagulation. The slurry was cooled to 20°C, dehydrated, and dried under vacuum to obtain a resin powder (MGMC-P) of a methacrylate copolymer (average particle size: 0.45 µm) (core: methyl methacrylate-n-butyl acrylate copolymer, shell: methyl methacrylate-glycidyl methacrylate copolymer).

40 parts of naphthenic process oil ("SUNTHENE (registered trademark) 450" manufactured by Japan Sun Oil Co., Ltd., naphthene content: 42 wt%, aromatic content: 15 wt%, paraffin content: 43 wt%), 30 parts of tetra-2-ethylhexyl pyromellitate, and 10 parts of 2,2'-methylenebis-4-methyl-6-tert-butylphenol were added to 100 parts by weight of the resulting resin powder (MGMC-P), and the mixture was mixed and defoamed using a vacuum high-speed defoaming-mixing device to obtain a plastisol.

The resulting plastisol was applied to a sheet made of SUS316 (150×150 mm) using a roll coater, and heated at 140°C for 10 minutes. This operation was repeated to form a film having a thickness of about 0.9 mm. The volume resistivity measured using the resulting film was 7.5×10¹⁴ Ω·cm.

### Reference Example 7

### Sheet formed of modified ethylene-vinyl acetate copolymer

97 parts of pellets of a modified ethylene-vinyl acetate copolymer (EVA6-S) were obtained in the same manner as in Reference Example 1, except that pellets of a commercially-available ethylene-vinyl acetate copolymer ("V206" manufactured by Ube-Maruzen Polyethylene Co., Ltd., vinyl acetate content: 6 wt%) were used, the resin temperature was set to 190°C, and the residence time was set to 170 to 180 seconds.

The FT-IR spectrum of the resulting pellets was measured. An absorption peak attributed to an Si-OCH₃ group was observed at 1,090 cm⁻¹, and an absorption peak attributed to an Si-CH₂ group was observed at 825 cm⁻¹ and 739 cm⁻¹. These absorption peaks were observed at positions differing from those (1,075 cm⁻¹, 808 cm⁻¹, and 766 cm⁻¹) of vinyltrimethoxysilane. It was thus confirmed that the modified ethylene-vinyl acetate copolymer (EVA6-S) included a methoxysilyl group.

A sheet (EVA6-S-F) having a thickness of 50 µm and a width of 500 mm was obtained in the same manner as in Reference Example 1, except that the pellets of the modified ethylene-vinyl acetate copolymer (EVA-S) were used, the molten resin temperature was set to 190°C, and the T-die temperature was set to 190°C.

Twenty sheets (EVA6-S-F) (formed of the modified ethylene-vinyl acetate copolymer) were stacked, and pressed (formed) at 150°C under vacuum using a vacuum laminator to obtain a specimen (sheet) having a thickness of about 1 mm. The volume resistivity measured using the resulting specimen was 3.5×10¹⁵ Ω·cm.

### Reference Example 8

### Sealing material including ethylene-vinyl acetate copolymer as main component

5 parts by weight of triallyl isocyanurate, 0.5 parts by weight of 3-methacryloxypropyltrimethoxysilane ("KBM-503" manufactured by Shin-Etsu Chemical Co., Ltd.), 1.0 part by weight of dicumyl peroxide ("PERCUMYL D" manufactured by NOF Corporation), and 0.4 parts by weight of 2-(2H-benzotriazol-2-yl)-4-(1,1,3,3-tetramethylbutyl)phenol were added to 95 parts by weight of pellets of an ethylene-vinyl acetate copolymer ("Evaflex (registered trademark) EV150" manufactured by DuPont-Mitsui Polychemicals Co., Ltd., vinyl acetate content: 33 wt%) to prepare a mixture. The mixture was extruded into a sealing material sheet (EVA33-F) having a thickness of 500 µm and a width of 500 mm using a T-die film molding device and a film take-up device (see Reference Example 1) (molten resin temperature: 90°C, T-die temperature: 90°C, embossing roll temperature: 50°C) while pressing one side of the extruded sheet against the embossing roll using a touch roll.

Two sealing material sheets (EVA33-F) (including the ethylene-vinyl acetate copolymer as the main component) were stacked, and heated and crosslinked at 150°C for 30 minutes under a pressure of 0.06 MPa using a vacuum laminator to obtain a specimen (sheet) having a thickness of about 1 mm. The volume resistivity measured using the resulting specimen was 2.7×10¹³ Ω·cm.

### Example 1

The sheet (PE-S-F5) produced in Reference Example 1 (modified polyethylene, thickness: 50 µm) and a release PET film (thickness: 100 µm) were stacked on a white glass sheet (450 mm×360 mm×3.2 (thickness) mm). The resulting laminate was preheated at 120°C for 5 minutes using a vacuum laminator ("PVL0505S" manufactured by Nisshinbo Mechatronics Inc.), and pressed at 120°C for 5 minutes under a pressure of 0.1 MPa. After cooling the laminate, the PET film was removed to obtain a glass sheet on which the modified polyethylene (PE-S) was stacked (secured).

The sealing material sheet (EVA33-F) produced in Reference Example 8, a crystalline silicon solar cell element (polycrystalline silicon cell, 155 mm×155 mm×200 (thickness) µm, manufactured by Advantec Co., Ltd., four cells connected in series through a tab wire), the sealing material sheet (EVA33-F), and a back-side protective sheet (polyvinyl fluoride/polyethylene terephthalate/polyvinyl fluoride: 37/250/37 µm, multilayer sheet) were sequentially stacked on the glass sheet on which the modified polyethylene (PE-S) was stacked (secured). A positive terminal and a negative terminal connected to the cell were pulled out from the back-side sealing material sheet and the back-side protective sheet.

The resulting laminate was preheated at 150°C for 5 minutes using a vacuum laminator ("PVL0505S" manufactured by Nisshinbo Mechatronics Inc.), and pressed at 150°C for 25 minutes under a pressure of 0.06 MPa. After cooling the laminate, the sealing material and the back-side protective sheet that protruded from the glass were removed by cutting, and the module was secured on an aluminum frame in a state in which a butyl rubber was provided on the end face. RTV silicone was provided to the cut area of the back-side protective layer (from which the terminal was pulled out), and cured to seal the module to obtain an experimental solar cell module.

The PID test was performed using the resulting solar cell module. The initial maximum output (Pm₀) was 13.95 W, and the maximum output (Pm) after subjecting the solar cell module to the environmental test for 96 hours was 13.88 W (retention ratio: 99.5%) (i.e., a significant decrease in output was not observed). A difference from the initial EL emission was not observed for each cell when the solar cell module was subjected to EL image measurement (i.e., PID did not occur).

### Comparative Example 1

An experimental solar cell module was obtained by sequentially stacking the sealing material sheet (EVA33-F) produced in Reference Example 8, a crystalline silicon solar cell element, the sealing material sheet (EVA33-F), and a back-side protective sheet on a white glass sheet, and subjecting the resulting laminate to vacuum lamination in the same manner as in Example 1 (i.e., the modified polyethylene layer was not stacked on the white sheet glass).

The PID test was performed using the resulting solar cell module. The initial maximum output (Pm₀) was 13.94 W, and the maximum output (Pm) after subjecting the solar cell module to the environmental test for 96 hours was 10.33 W (retention ratio: 74.1 %) (i.e., a significant decrease in output was observed). Very weak EL emission was observed for one of the four cells when the solar cell module was subjected to EL image measurement (i.e., PID occurred).

### Example 2

An experimental solar cell module was obtained in the same manner as in Example 1, except that the sheet (PE-S-F2) produced in Reference Example 1 (modified polyethylene, thickness: 20 µm) was used instead of the sheet (PE-S-F5) (modified polyethylene, thickness: 50 µm).

The PID test was performed using the resulting solar cell module. The initial maximum output (Pm₀) was 13.97 W, and the maximum output (Pm) after subjecting the solar cell module to the environmental test for 96 hours was 13.86 W (retention ratio: 99.2%) (i.e., a significant decrease in output was not observed). A difference from the initial EL emission was not observed for each cell when the solar cell module was subjected to EL image measurement (i.e., PID did not occur).

### Example 3

An experimental solar cell module was obtained in the same manner as in Example 1, except that the sheet (EOC-S-F) produced in Reference Example 2 (modified ethylene-1-octene copolymer, thickness: 50 µm) was used instead of the sheet (PE-S-F5) (modified polyethylene, thickness: 50 µm).

The PID test was performed using the resulting solar cell module. The initial maximum output (Pmo) was 13.96 W, and the maximum output (Pm) after subjecting the solar cell module to the environmental test for 96 hours was 13.87 W (retention ratio: 99.4%) (i.e., a significant decrease in output was not observed). A difference from the initial EL emission was not observed for each cell when the solar cell module was subjected to EL image measurement (i.e., PID did not occur).

### Example 4

An experimental solar cell module was obtained in the same manner as in Example 1, except that the sheet (HBC-S-F) produced in Reference Example 3 (modified hydrogenated block copolymer, thickness: 50 µm) was used instead of the sheet (PE-S-F5) (modified polyethylene, thickness: 50 µm).

The PID test was performed using the resulting solar cell module. The initial maximum output (Pm₀) was 13.98 W, and the maximum output (Pm) after subjecting the solar cell module to the environmental test for 96 hours was 13.94 W (retention ratio: 99.7%) (i.e., a significant decrease in output was not observed). A difference from the initial EL emission was not observed for each cell when the solar cell module was subjected to EL image measurement (i.e., PID did not occur).

### Example 5

100 parts by weight of the modified hydrogenated block copolymer (HBC-S) produced in Reference Example 3 was dissolved in 300 parts by weight of toluene. The resulting solution was applied to a white glass sheet (450 mm×360 mm×3.2 (thickness) mm) using a bar coater, and dried. The thickness of the film formed on the glass sheet was 8 µm.

An experimental solar cell module was obtained by sequentially stacking the sealing material sheet (EVA33-F) produced in Reference Example 8, a crystalline silicon solar cell element, the sealing material sheet (EVA33-F), and a back-side protective sheet on the white sheet glass (on which the film of the modified hydrogenated block copolymer (HBC-S) was formed), and subjecting the resulting laminate to vacuum lamination in the same manner as in Example 1.

The PID test was performed using the resulting solar cell module. The initial maximum output (Pm₀) was 13.96 W, and the maximum output (Pm) after subjecting the solar cell module to the environmental test for 96 hours was 13.59 W (retention ratio: 97.3%) (i.e., a significant decrease in output was not observed). A difference from the initial EL emission was not observed for each cell when the solar cell module was subjected to EL image measurement (i.e., PID did not occur).

### Example 6

A solution of the modified hydrogenated block copolymer (HBC-S) produced in Reference Example 3 was applied to a white glass sheet (450 mm×360 mmx3.2 (thickness) mm) using a bar coater, and dried to form a film having a thickness of 3 µm.

An experimental solar cell module was obtained by sequentially stacking the sealing material sheet (EVA33-F) produced in Reference Example 8, a crystalline silicon solar cell element, the sealing material sheet (EVA33-F), and a back-side protective sheet on the white sheet glass (on which the film of the modified hydrogenated block copolymer (HBC-S) was formed), and subjecting the resulting laminate to vacuum lamination in the same manner as in Example 1.

The PID test was performed using the resulting solar cell module. The initial maximum output (Pm₀) was 13.97 W, and the maximum output (Pm) after subjecting the solar cell module to the environmental test for 96 hours was 12.74 W (retention ratio: 91.1 %) (i.e., a decrease in output was significantly smaller than that of Comparative Example 1). A significant decrease in EL emission was not observed when the solar cell module was subjected to EL image measurement (i.e., occurrence of PID was not observed).

### Example 7

An experimental solar cell module was obtained in the same manner as in Example 1, except that a soda glass sheet (450 mm×360 mm×3.2 (thickness) mm) was used instead of the white glass sheet, and the sheet (HBC-S-F) produced in Reference Example 3 (modified hydrogenated block copolymer, thickness: 50 µm) was used instead of the sheet (PE-S-F5) (modified polyethylene, thickness: 50 µm).

The PID test was performed using the resulting solar cell module. The initial maximum output (Pm₀) was 13.14 W (i.e., the initial maximum output decreased by about 6% as compared with the case of using the white glass sheet due to absorption of light by the soda glass sheet), and the maximum output (Pm) after subjecting the solar cell module to the environmental test for 96 hours was 13.10 W (retention ratio: 99.7%) (i.e., a significant decrease in output was not observed). A difference from the initial EL emission was not observed for each cell when the solar cell module was subjected to EL image measurement (i.e., PID did not occur).

### Example 8

An experimental solar cell module was obtained in the same manner as in Example 1, except that the sheet (EEAC-S-F) produced in Reference Example 4 (modified ethylene-ethyl acrylate copolymer, thickness: 50 µm) was used instead of the sheet (PE-S-F5) (modified polyethylene, thickness: 50 µm).

The PID test was performed using the resulting solar cell module. The initial maximum output (Pm₀) was 13.94 W, and the maximum output (Pm) after subjecting the solar cell module to the environmental test for 96 hours was 13.82 W (retention ratio: 99.1%) (i.e., a significant decrease in output was not observed). A difference from the initial EL emission was not observed for each cell when the solar cell module was subjected to EL image measurement (i.e., PID did not occur).

### Example 9

An experimental solar cell module was obtained in the same manner as in Example 1, except that the sheet (EMAI-F) produced in Reference Example 5 (ionomer resin, thickness: 50 µm) was used instead of the sheet (PE-S-F5) (modified polyethylene, thickness: 50 µm).

The PID test was performed using the resulting solar cell module. The initial maximum output (Pm₀) was 13.93 W, and the maximum output (Pm) after subjecting the solar cell module to the environmental test for 96 hours was 13.84 W (retention ratio: 99.4%) (i.e., a significant decrease in output was not observed). A difference from the initial EL emission was not observed for each cell when the solar cell module was subjected to EL image measurement (i.e., PID did not occur).

### Example 10

The plastisol (including the resin powder of the methacrylate copolymer (MGMC)) produced in Reference Example 6 was applied to a white glass sheet (450 mm×360 mm×3.2 (thickness) mm) using a bar coater, and dried at 140°C for 10 minutes. The thickness of the film formed on the glass sheet was 12 µm.

An experimental solar cell module was obtained by sequentially stacking the sealing material sheet (EVA33-F) produced in Reference Example 8, a crystalline silicon solar cell element, the sealing material sheet (EVA33-F), and a back-side protective sheet on the white sheet glass (on which the film of the methacrylate copolymer (MGMC) was formed), and subjecting the resulting laminate to vacuum lamination in the same manner as in Example 1.

The PID test was performed using the resulting solar cell module. The initial maximum output (Pm₀) was 13.39 W, and the maximum output (Pm) after subjecting the solar cell module to the environmental test for 96 hours was 12.75 W (retention ratio: 95.2%) (i.e., a significant decrease in output was not observed). A significant difference from the initial EL emission was not observed for each cell when the solar cell module was subjected to EL image measurement (i.e., PID did not occur).

### Example 11

An experimental solar cell module was obtained in the same manner as in Example 1, except that the sheet (EVA6-S-F) produced in Reference Example 7 (modified ethylene-vinyl acetate copolymer, thickness: 50 µm) was used instead of the sheet (PE-S-F5) (modified polyethylene, thickness: 50 µm).

The PID test was performed using the resulting solar cell module. The initial maximum output (Pm₀) was 13.95 W, and the maximum output (Pm) after subjecting the solar cell module to the environmental test for 96 hours was 13.81 W (retention ratio: 99.0%) (i.e., a significant decrease in output was not observed). A difference from the initial EL emission was not observed for each cell when the solar cell module was subjected to EL image measurement (i.e., PID did not occur).

### Reference Example 9

### Polyethylene sheet provided with adhesive layer

0.4 parts of 2-(2H-benzotriazol-2-yl)-4-(1,1,3,3-tetramethylbutyl)phenol (see Reference Example 1) was added to 100 parts of pellets of commercially-available low-density polyethylene (see Reference Example 1) to prepare a mixture. The mixture was extruded into a sheet (PE-F) having a thickness of 50 µm and a width of 500 mm using a T-die film molding device and a film take-up device (see Reference Example 1) (molten resin temperature: 200°C, T-die temperature: 200°C, embossing roll temperature: 50°C).

The toluene solution of the modified hydrogenated block copolymer (HBC-S) prepared in Example 5 was applied to the resulting polyethylene sheet using a bar coater, and dried. The thickness of the film formed on the polyethylene sheet was 8 µm.

A film of the modified hydrogenated block copolymer was formed on the other side of the polyethylene sheet in the same manner as described above.

### Example 12

The polyethylene sheet produced in Reference Example 8 (provided with the adhesive layer formed of the modified hydrogenated block copolymer (HBC-S)), the sealing material sheet (EVA-F) produced in Reference Example 7, a crystalline silicon solar cell element, the sealing material sheet (EVA-F), and a back-side protective sheet were sequentially stacked on a white sheet glass (450 mm×360 mm×3.2 (thickness) mm). The resulting laminate was preheated at 150°C for 5 minutes using a vacuum laminator, and pressed at 150°C for 25 minutes under a pressure of 0.06 MPa. The resulting module was cooled, and secured on an aluminum frame in the same manner as in Example 1 to obtain an experimental solar cell module.

The PID test was performed using the resulting solar cell module. The initial maximum output (Pm₀) was 13.84 W, and the maximum output (Pm) after subjecting the solar cell module to the environmental test for 96 hours was 13.81 W (retention ratio: 99.8%) (i.e., a significant decrease in output was not observed). A difference from the initial EL emission was not observed for each cell when the solar cell module was subjected to EL image measurement (i.e., PID did not occur).

### Example 13

100 parts by weight of toluene and 0.4 parts of 2-(2H-benzotriazol-2-yl)-4-(1,1,3,3-tetramethylbutyl)phenol (see Reference Example 1) were added to 100 parts by weight of a polyisobutylene oligomer (in which a methoxysilyl group is introduced at the polymer terminal) ("Epion (registered trademark) 303S" manufactured by Kaneka Corporation) to effect dissolution. The resulting solution was applied to a white glass sheet (450 mm×360 mm×3.2 (thickness) mm) using a bar coater. The applied solution was dried to remove volatile components, and allowed to stand at a temperature of 85°C and a humidity of 85% tor 24 hours in a constant temperature-humidity chamber to form a cured polyisobutylene film on the surface of the glass sheet. The thickness of the film formed on the glass sheet was 25 µm.

An experimental solar cell module was obtained by sequentially stacking the sealing material sheet (EVA33-F) produced in Reference Example 8, a crystalline silicon solar cell element, the sealing material sheet (EVA33-F), and a back-side protective sheet on the white sheet glass (on which the cured polyisobutylene film was formed), and subjecting the resulting laminate to vacuum lamination in the same manner as in Example 1.

The PID test was performed using the resulting solar cell module. The initial maximum output (Pm₀) was 13.95 W, and the maximum output (Pm) after subjecting the solar cell module to the environmental test for 96 hours was 13.85 W (retention ratio: 99.3%) (i.e., a significant decrease in output was not observed). A difference from the initial EL emission was not observed for each cell when the solar cell module was subjected to EL image measurement (i.e., PID did not occur).

The following were confirmed from the results obtained in the examples and the comparative examples.

Occurrence of PID can be suppressed by forming a layer that is formed of a transparent resin and bonded to glass between transparent glass and a sealing material that includes an ethylene-vinyl acetate copolymer as the main component (see Examples 1 to 13).

It is possible to sufficiently suppress occurrence of PID when the transparent resin layer has a thickness of 5 µm to 10 µm or more (see Examples 1 to 5 and 7 to 13).

Occurrence of PID can be suppressed even when the transparent resin layer has a thickness of less than 5 µm (see Example 6).

It is possible to suppress occurrence of PID by providing the transparent resin layer even when soda glass having a high metal content as compared with white sheet glass is used (see Example 7).

When using an ethylene-vinyl acetate copolymer, occurrence of PID can be suppressed by forming a layer formed of an ethylene-vinyl acetate copolymer that has a low vinyl acetate content and a high volume resistivity as compared with the ethylene-vinyl acetate copolymer used for the sealing material between transparent glass and the sealing material (see Example 11).

When a sealing material that includes an ethylene-vinyl acetate copolymer as the main component and has a volume resistivity of less than 1×10¹⁴ Ω·cm is used, PID may occur when a high voltage is applied to the crystalline silicon solar cell module at a high temperature and a high humidity (see Comparative Example 1).

### INDUSTRIAL APPLICABILITY

Since the solar cell module according to the embodiments of the invention can suppress occurrence of PID at a high temperature and a high humidity and maintain stable output characteristics even when a sealing material formed of a general-purpose ethylene-vinyl acetate copolymer is used, the solar cell module is advantageous from the view point of supply and economic efficiency as compared with the case of using a novel sealing material, and has high industrial value.

### REFERENCE SIGNS LIST

- 1: Front-side transparent glass
- 2: Sealing material layer that includes ethylene-vinyl acetate copolymer as main component
- 3: Crystalline silicon solar cell element
- 4: Back-side protective layer
- 5: Transparent resin layer
- 6: Adhesive layer

## Claims

1. A solar cell module comprising at least a front-side transparent glass, a sealing material layer that comprises an ethylene-vinyl acetate copolymer having a vinyl acetate content of 20 to 35 wt% as a main component, a crystalline silicon solar cell element that is embedded in the sealing material, and a back-side protective layer that is formed of a resin sheet or glass, the front-side transparent glass, the sealing material layer, the crystalline silicon solar cell element, and the back-side protective layer being stacked sequentially from a light-receiving side, a layer that is formed of a transparent resin and bonded to the front-side transparent glass being formed between the front-side transparent glass and the sealing material layer.

2. The solar cell module according to claim 1, wherein the layer that is formed of the transparent resin has a thickness of 5 to 200 µm.

3. The solar cell module according to claim 1 or 2, wherein the transparent resin has a volume resistivity at 25°C of 1×10¹⁴ Ω·cm or more.

4. The solar cell module according to claim 1, wherein the transparent resin is at least one transparent resin selected from (1) a polyolefin, (2) a hydrogenated block copolymer obtained by hydrogenating 90% or more of unsaturated bonds of a block copolymer that comprises at least two polymer blocks [A] and at least one polymer block [B], the polymer block [A] comprising a repeating unit derived from an aromatic vinyl compound as a main component, and the polymer block [B] comprising a repeating unit derived from a linear conjugated diene compound as a main component, (3) an ethylene-(meth)acrylate copolymer, (4) an ionomer obtained by reacting an ethylene-unsaturated carboxylic acid random copolymer with a metal compound, (5) a methacrylate (co)polymer, (6) an ethylene-vinyl acetate copolymer having a vinyl acetate content of less than 20 wt%, and (7) a modified polymer obtained by introducing an alkoxysilyl group into at least one polymer selected from the polymers (1) to (6).

5. A method for producing the solar cell module according to claim 1, the method comprising sequentially stacking a sheet that is formed of a transparent resin, a sealing material sheet that comprises an ethylene-vinyl acetate copolymer as a main component, a crystalline silicon solar cell element, a sealing material sheet that comprises an ethylene-vinyl acetate copolymer as a main component, and a back-side protective material that is formed of a resin sheet or glass on a front-side transparent glass to obtain a laminate, and pressing the laminate with heating to integrate the laminate.

6. A method for producing the solar cell module according to any one of claims 1 to 3, the method comprising stacking and securing a layer that is formed of a transparent resin on a front-side transparent glass, sequentially stacking a sealing material sheet that comprises an ethylene-vinyl acetate copolymer as a main component, a crystalline silicon solar cell element, a sealing material sheet that comprises an ethylene-vinyl acetate copolymer as a main component, and a back-side protective material that is formed of a resin sheet or glass on the front-side transparent glass on which the layer that is formed of the transparent resin is stacked to obtain a laminate, and pressing the laminate with heating to integrate the laminate.
